# EUROPEAN PATENT APPLICATION

(11) **EP 3 934 094 A1**
(43) Date of publication of application: **05.01.2022**
(21) Application number: 20020328.9
(22) Date of filing: 17.07.2020
(51) Int. Cl.: H02S 20/26, H01L 31/048, B32B 3/02, E04F 13/077, E04F 13/08

(54) **BUILDING-INTEGRATED PHOTOVOLTAIC SYSTEM**

(30) Priority: 04.07.2020 US 202016920671
(71) Applicant: MITREX INC., Toronto, ON M9W 2Z4 (CA)
(72) Inventor: Hadizadeh, Danial, Toronto, M9W 2Z4 (CA)
(74) Representative: Reich, Jochen

(57) **Abstract**

Described is a structurally and aesthetically superior building-integrated photovoltaic (BIPV) system for converting solar energy into usable electric energy. The layered BIPV system is comprised of an antireflective coating, at least one substrate, at least one solar cell, an anchoring element, stone lamina back rails, an exterior side, an interior side, and adhesives or fasteners. A substrate thereof has a visible stone, glass, or other aesthetic feature. The layered BIPV system may also include an insulation layer, an inert gas fill, a fire-resistant seal, or a transparent intumescent coat. The layered BIPV system exhibits desirable structural properties with respect to structural pressure resistance, water penetration, air penetration, missile impact resistance, cyclic pressure loading resistance, flexural strength, compressive strength, shear strength, tensile strength, and fire resistance and complies with building code standards for the same.

## Description

### FIELD OF THE INVENTION

The present specification relates generally to building-integrated photovoltaics (BIPVs) and more specifically to a layered BIPV system that provides an aesthetically appealing design and superior structural properties.

### BACKGROUND OF THE INVENTION

BIPVs are materials that replace or augment traditional building materials in a building envelope, like cladding, and which generate electrical energy from solar energy. Photovoltaic modules have historically been mounted on buildings in areas without easy access to an electric power grid, but photovoltaics have become increasingly popular in urban centers as a means of generating alternative energy and promoting sustainable green technology. Furthermore, the electrical energy generated by BIPVs may be used not only to supply power to the building the photovoltaics are installed on, but surplus energy may be transferred or sold to an electrical power grid.

BIPVs generally fall into one of two module categories. First, photovoltaics can be incorporated into the building structure itself. Architectural elements like walls or roofs may be replaced with BIPVs to help convert solar energy that would come into contact with these elements into usable electrical energy. Many of these architectural elements, like the roof of a building or the external walls of a skyscraper, are located and positioned in such a way that it has significant natural exposure to solar energy. Consequently, these high-exposure architectural elements are suitable candidates for replacement with BIPVs. Second, photovoltaics can be retrofitted onto existing buildings by mounting the BIPVs onto the façade of the building over pre-existing structures. This permits even older architecture to receive an upgrade that generates some renewable energy without materially interfering with the original building structure.

There are several disadvantages to BIPVs currently found in the prior art. More particularly, BIPVs fail to meet structural performance standards for cladding materials and have undesirable aesthetic profiles. BIPVs in the prior art are not certified by North American building code standards with respect to structural pressure, water penetration, air infiltration, air exfiltration, impact resistance, wind resistance, flexural strength, compressive strength, shear strength, tensile strength, fire resistance, aesthetics, and general weather protection. BIPVs in the prior art also suffer from poor ventilation and are not easy to install.

Accordingly, there is a need for improvements in the prior art.

### SUMMARY OF THE INVENTION

In an embodiment of the present invention, there is a layered building-integrated photovoltaic (BIPV) system, comprising an antireflective coating, at least one substrate, at least one solar cell, an anchoring element, stone lamina back rails, an exterior side, an interior side and at least one fastener (a mechanical fastener or an adhesive), wherein at least one fastener is used to connect any combination of the at least one substrate, the at least one solar cell, the anchoring element, and the stone lamina back rails and wherein at least one of the at least one substrate has an aesthetic feature comprised of one or more of: visible stone, glass, or other materials.

According to an embodiment, a solar cell may be a crystalline silicon solar cell with a solar light redirecting film, an integrated back contact crystalline silicon solar cell, a thin film solar cell that may include a transparent conducting oxide layer, or a heterojunction solar cell. The anchoring element may be an aluminum honeycomb sandwich panel or a PVC foam core sandwiched between aluminum sheets. The visible stone or glass aesthetic can be created by using at least one of glass tinting, screen printing, ceramic frit printing, digital UV printing, sputtering, tinted glass with or without a pattern, or textured glass (including sandblasted glass, acid etched glass, solar texture glass, pinhead glass, or glass with any other texture) and wherein the visible stone or glass aesthetic includes limestone, marble, granite, onyx, and other aesthetics. Each of these processes may involve tempering the glass afterwards. Furthermore, substrates may be comprised of thin lime soda glass, metal, a Tedlar film, low iron float glass, or another glass and may have a UV resistant or insulating coating.

According to an embodiment, there may be an insulation layer, a cavity created between a first and second substrate that is filled with inert gas and sealed with a fire retardant seal and which contains a solar cell, two glass substrates that are laminated with a transparent intumescent coat and encapsulant, a layer of stone laminate, or a layer of onyx laminate.

According to an embodiment, the layered BIPV system or an adhesive, substrate, or anchoring element thereof exhibits desirable structural properties with respect to at least one of structural pressure resistance, water penetration, air penetration, missile impact resistance, cyclic pressure loading resistance, flexural strength, compressive strength, shear strength, tensile strength, or fire resistance, inclusive of fire retardance. Such structural properties may be such that the layered BIPV system or an adhesive, substrate, or anchoring element thereof is in compliance with at least one building code standard.

Other aspects and features according to the present application will become apparent to those ordinarily skilled in the art upon review of the following description of embodiments of the invention in conjunction with the accompanying figures.

### BRIEF DESCRIPTION OF THE FIGURES

The principles of the invention may better be understood with reference to the accompanying figures provided by way of illustration of an exemplary embodiment, or embodiments, incorporating principles and aspects of the present invention, and in which:
FIGs. 1(a) to 1(j) show a visible limestone, marble, granite, or other aesthetic design that is incorporated into a layered BIPV system embodiment;
FIG. 2 shows a layered BIPV system, according to an embodiment;
FIG. 3 shows a layered BIPV system with an alternative anchoring element comprised of a PVC sandwich panel with aluminum skin, according to an embodiment;
FIG. 4 shows a layered BIPV system with a second substrate and a visible structural adhesive layer, according to an embodiment;
FIG. 5 shows a layered BIPV system with an insulation layer, according to an embodiment;
FIG. 6 shows a layered BIPV system with a cavity created between a first and second substrate that is filled with inert gas and sealed with a fire-retardant seal and which contains a solar cell, according to an embodiment;
FIG. 7 shows a layered BIPV system with two glass substrates that are laminated with a transparent intumescent coat and encapsulant, according to an embodiment;
FIG. 8 shows a layered BIPV system with a layer of stone laminate, according to an embodiment;
FIG. 9 shows a layered BIPV system with a layer of onyx laminate, according to an embodiment;
FIGs. 10(a) to 10(c) show a method for installing a layered BIPV system on a building, according to an embodiment;
FIG. 11 shows the deflection gauge locations used in testing structural deflection of an embodiment; and
FIG. 12 shows how panels of a layered BIPV system were attached to a substrate and the location of an opening used in testing fire resistance.

### DETAILED DESCRIPTION OF ASPECTS OF THE INVENTION

The description that follows, and the aspects described therein, are provided by way of illustration of an example, or examples, of particular aspects of the principles of the present invention. These examples are provided for the purposes of explanation, and not of limitation, of those principles and of the invention. In the description, like parts are marked throughout the specification and the drawings with the same respective reference numerals. The drawings are not necessarily to scale and in some instances proportions may have been exaggerated in order to more clearly to depict certain features of the invention.

According to an aspect, this description relates to a layered building integrated photovoltaic system, comprising an antireflective coating, at least one substrate or encapsulant, at least one solar cell, an anchoring element, stone lamina back rails, an exterior side, an interior side, and where at least one adhesive or mechanical fastener is used to connect any combination of the at least one substrate or encapsulant, the at least one solar cell, the anchoring element, or the stone lamina back rails and wherein at least one of the at least one substrate or encapsulant has a visible stone or glass aesthetic.

According to a further aspect, from the exterior side to the interior side, there is positioned the antireflective coating, a first substrate, a first encapsulant, the at least one solar cell, a second encapsulant, the anchoring element, and the stone lamina back rails. According to a further aspect, there is a second substrate between the second encapsulant and the anchoring element, an insulating layer between the second encapsulant and the second substrate, or a fire retardant or moisture barrier sealant.

According to a further aspect, from the exterior side to the interior side, there is positioned the antireflective coating, a first substrate separated by metal spacers from a second substrate to create a cavity sealed with a fire retardant seal and in which is the at least one solar cell and an inert gas fill, the anchoring element, and the stone lamina back rails.

According to a further aspect, from the exterior side to the interior side, there is positioned the antireflective coating, a first substrate laminated with a transparent intumescent coat and a first encapsulant to a second substrate with a printed surface, the at least one solar cell, a second encapsulant, the anchoring element, and the stone lamina back rails.

According to a further aspect, from the exterior side to the interior side, there is positioned the antireflective coating, a semitransparent thin film solar module that is either coloured or clear and comprised of a first and second glass substrate on either side of the at least one solar cell, stone laminate secured using structural adhesive, the anchoring element, and the stone lamina back rails.

According to a further aspect, from the exterior side to the interior side, there is positioned the antireflective coating, a first substrate comprised of glass, a first encapsulant, a second substrate comprised of onyx laminate, a second encapsulant, the at least one solar cell, a third encapsulant, the anchoring element, and the stone lamina back rails.

Further, this description relates to at least one solar cell that may be a crystalline silicon solar cell with a solar light redirecting film, an integrated back contact crystalline silicon solar cell, a thin film solar cell that may include a transparent conducting oxide layer, or a heterojunction solar cell. The anchoring element may be either of an aluminum honeycomb sandwich panel or a polyvinyl chloride (PVC) foam core sandwiched between 0.5 mm to 2.0 mm thick aluminum sheets. The visible stone or glass aesthetic can be created by using at least one of glass tinting, screen printing, ceramic frit printing, digital UV printing, sputtering, tinted glass with or without a pattern, or textured glass (including sandblasted glass, acid etched glass, solar texture glass, pinhead glass, or glass with any other texture) and wherein the visible stone or glass aesthetic includes limestone, marble, granite, onyx, and other stone laminate aesthetics. Each of these processes for creating a glass aesthetic may involve tempering the glass afterwards. Furthermore, substrates may be comprised of thin lime soda glass, metal, a Tedlar film, low iron float glass, or another glass and which may have a UV resistant or insulating coating.

Still further, this description relates to a layered BIPV system that, when subject to a uniform static air pressure difference of ±3840 Pa, maximum net deflection does not exceed 4.14 mm or when subject to a uniform static air pressure difference of ±5760 Pa, net permanent deflection does not exceed 0.10 mm for a test subject of a length of 2.44 m or no more than 0.004 % of the length of the substrate or encapsulant.

Still further, this description relates to a layered BIPV system that, when subject to a uniform static air pressure difference of 720 Pa with water applied to the exterior side there is no water penetration.

Still further, this description relates to a layered BIPV system that, when subject to an air pressure difference of +75 Pa or -75 Pa the rate of air leakage does not exceed air infiltration and exfiltration levels of 0.00 L/((s)(m²)) or 0.01 L/((s)(m²)), respectively.

Still further, this description relates to a layered BIPV system that experiences no material structural deformation, deflection, or breakage when impacted with a large missile comprised of lumber with a mass of 4100 g ± 100 g and dimensions 2 inches by 4 inches by 8 feet ± 4 inches at an impact speed of 50 feet/second in wind zones with isotachs of no more than 150 mph. Additionally, there is no material structural deformation, deflection, or breakage when subject to a cyclic wind pressure of ±2880 Pa after impact with the large missile.

Still further, this description relates to a layered BIPV system that experiences no material deformation, deflection, or breakage when subject to a flexural pressure of approximately 2630 psi, a compressive pressure of approximately 278 psi, or a shear pressure of approximately 137 psi.

Still further, this description relates to a layered BIPV system that uses adhesives which create adhesives bonds that do not fail when subject to tensile pressure of 137 psi.

Still further, this description relates to a layered BIPV system that when exposed to a post flashover fire in a compartment venting through an opening in the exterior side results in a maximum flame spread of no more than 2.0 m above the opening or a maximum average heat flux of no more than 14.4 kW/m².

### Integrating Aesthetically Appealing Designs

A key consideration in constructing building structures is the aesthetic profile created by a building's façade. It is especially desirable for a construction company to create structures that offer both utility and aesthetic appeal. In the case of the former, BIPVs can be used to generate electrical energy from solar energy that comes into contact with the surface of a building. In the case of the latter, the materials used in manufacturing a building and the designs thereof may be altered to suit a particular architectural aesthetic or communicate a desirable atmosphere to property investors or prospective building residents or visitors.

However, utility and aesthetic appeal are often at odds with one another. In the construction industry, there are substantial challenges in designing BIPVs that are structurally sound, provide adequate solar energy conversion efficiency, and are aesthetically appealing. With the rising popularity of green technology, BIPVs that offer superior structural properties, consistent solar energy conversion efficiency, and which may be customized with different aesthetic designs would be especially appealing to replace or augment architectural elements in both new and old buildings.

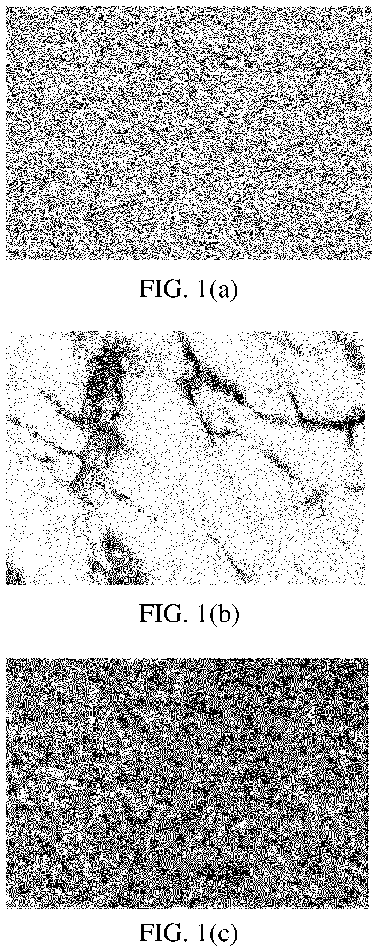

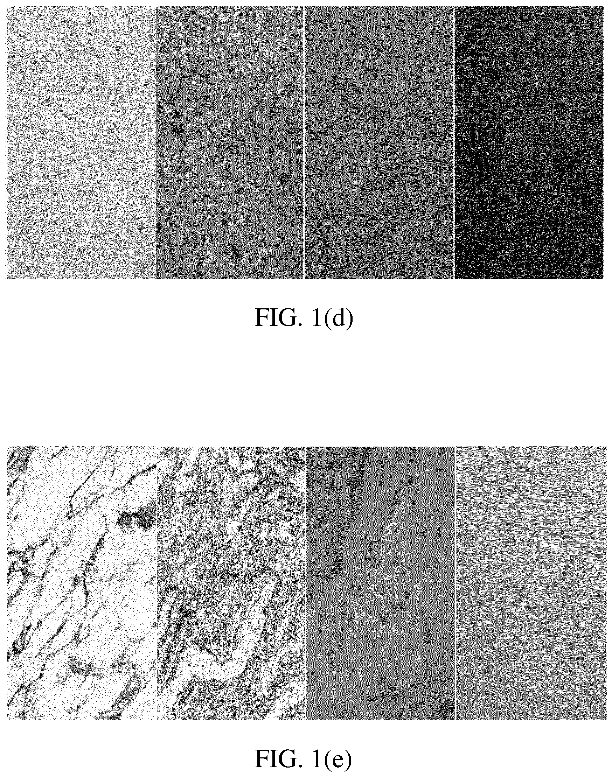

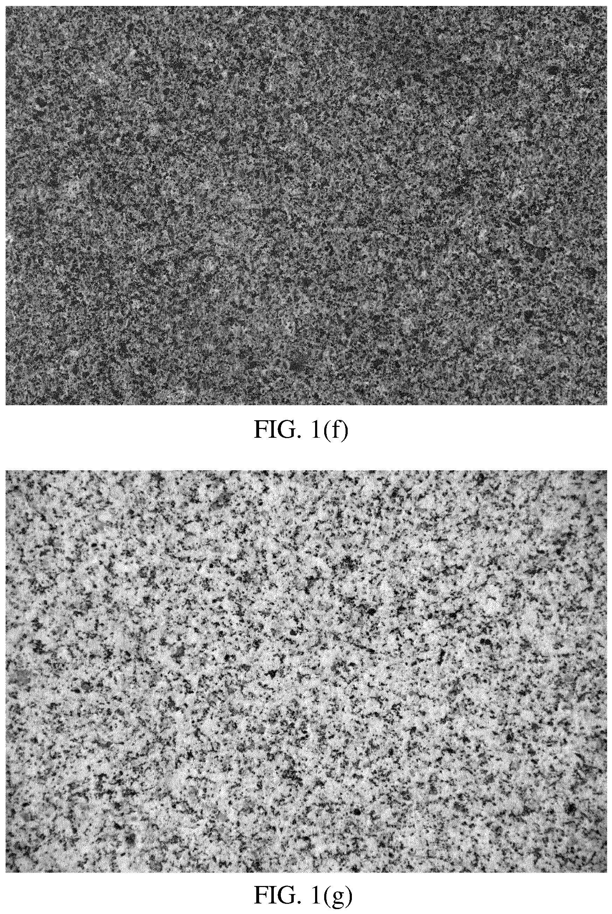

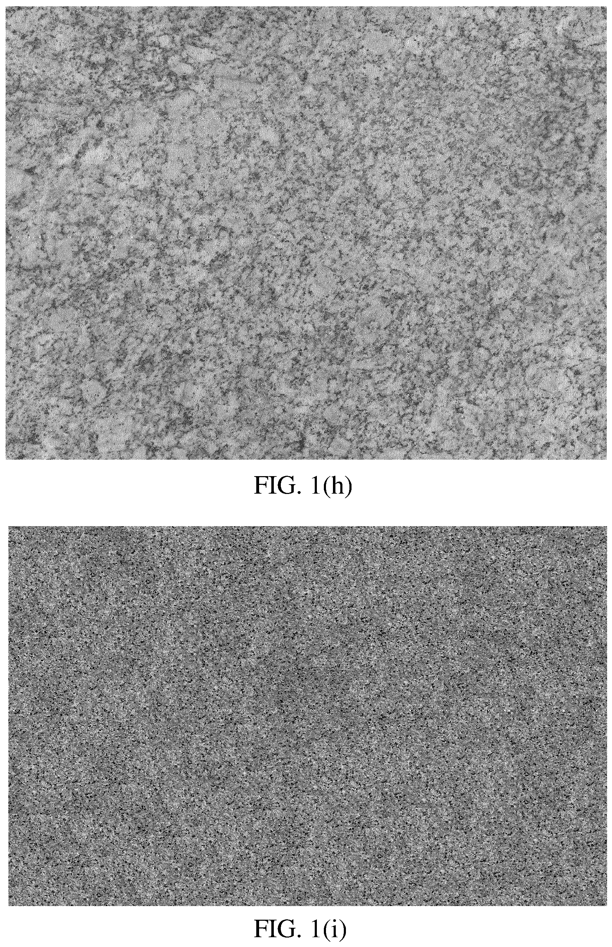

According to an aspect, a layered BIPV system is created with a visible stone, glass, or other aesthetic. According to aspects shown in FIGs. 1(a) to 1(j), a visible limestone, marble, granite, or other aesthetic design is incorporated into the BIPV.

According to an aspect, the opacity, transparency, or colours of the layers of a layered BIPV system can vary to control solar energy permeability. Varying the opacity, transparency, or colour of materials that comprise the layered BIPV influences the quantity of solar energy available for conversion and the electrical energy output of the BIPV by changing how much solar energy from incident photons will contact the surface of a solar cell.

Varying opacity, transparency, colour, or pattern can similarly impact the overall aesthetic design of the BIPV aspects, since a more glassy aesthetic can be created by improving transparency or an overall aesthetic design can be created by combining the individual aesthetic designs of more than one layer where at least one layer is at least partly transparent such that an at least second layer is visible. The combined use of partially transparent layers significantly broadens the number and diversity of aesthetic design choices, since some degree of transparency can permit more than one aesthetic design to be visible and such transparency can permit aesthetic designs that incorporate third-dimension depth into the overall aesthetic design of the BIPV. Patterns may include designs where pixels are randomly removed. For instance, a checkerboard will remove 50% of the pixels in a design and, consequently, increase transmission by approximately 50%. There are various patterns with different degrees of pixel removal, like other designs that remove 19/20 pixels or 95% of the pixels.

### BIPV Module Layering

According to an aspect as described herein, a layered BIPV system is comprised of an antireflective coating, at least one substrate, an encapsulant, at least one solar cell, an anchoring element, stone lamina back rails, an exterior side, and an interior side wherein at least one fastener (mechanical or adhesive) is used to connect any combination of the at least one substrate, the at least one solar cell, the anchoring element, and the stone lamina back rails and wherein at least one of the at least one substrate has a visible stone, glass, or other aesthetic.

The antireflective coating is designed to improve the light transmittance and hydrophobic character of the BIPV and provides self-cleaning properties to the BIPV module surface. The antireflective coating may include single or multi layered metal oxide films and moth eye structured patterns.

The at least one substrate may include a first substrate with a visible stone or glass aesthetic, like those shown in FIGs. 1(a) to 1(j). Such an aesthetic design can be achieved by any combination of glass tinting, screen printing, ceramic frit printing with balanced print and colour opacity, digital ultraviolet (UV) printing with optimized porosity and the use of an encapsulant to protect the paint, sputtering, or by using tinted glass either with or without a pattern or textured glass (including sandblasted glass, acid etched glass, solar texture glass, pinhead glass, or glass with any other texture). Each of these processes may involve tempering the glass afterwards.

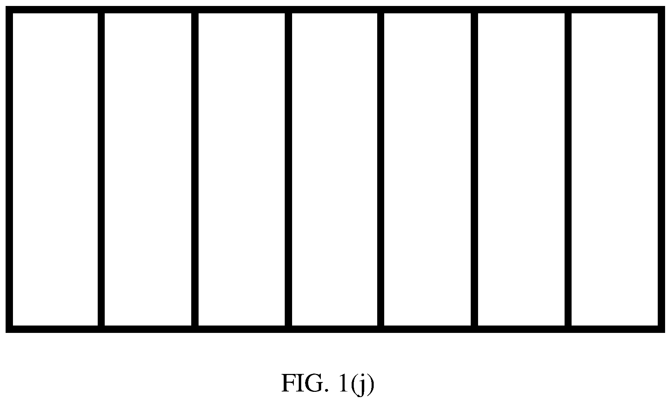

Figure 1(j) displays a particular aesthetic pattern. Due to the schematic character of the figures no colours are introduced, which may be present.

The encapsulant may include a first encapsulant compatible with the at least one solar cell and which may be coloured or have a transparency or opacity that enhances the desired aesthetic of the BIPV.

The at least one solar cell may be at least one of a crystalline silicon solar cell with a solar light redirecting film, an integrated back contact solar cell, a thin film solar cell (for example, copper indium gallium selenide ("CIGS") solar cells), or a heterojunction solar cell. Any such solar cell may be selected or designed to, whether alone or in combination with other components of the BIPV, improve the BIPV's efficiency at converting solar energy into usable energy or improve the aesthetic appeal of the BIPV. Where the at least one solar cell is a thin film solar cell, there is an adjacent contact layer that may be comprised of molybdenum or another metal. Additionally, the encapsulant may include a second encapsulant where crystalline silicon solar cells are used.

The at least one substrate may include a second substrate comprised of glass, metal, or at least one Tedlar^{®} back sheet and which may be accompanied by a UV resistant coating or a passive insulating layer. The second substrate could be a dielectric materials which includes glass, coated or anodized metals, or a plastic back sheet, like one comprised of polyethylene terephthalate (PET), polytetrafluoroethylene (PTFE), or polyvinylidene fluoride (PVDF).

The anchoring element may be an aluminum honeycomb sandwich panel or a polyvinyl chloride (PVC) foam core sandwiched between aluminum sheets. Where used, the PVC foam core is sandwiched between aluminum sheets with thickness between 0.5 to 2.0 mm. The anchoring element may be attached to the stone lamina back rails to install the layered BIPV on a building.

The at least one structural adhesive may be fire retardant and compatible with substrates with different thermal expansion properties. Additionally, a fire retardant and moisture barrier sealant may be applied around the BIPV, possibly after lamination with at least one encapsulant.

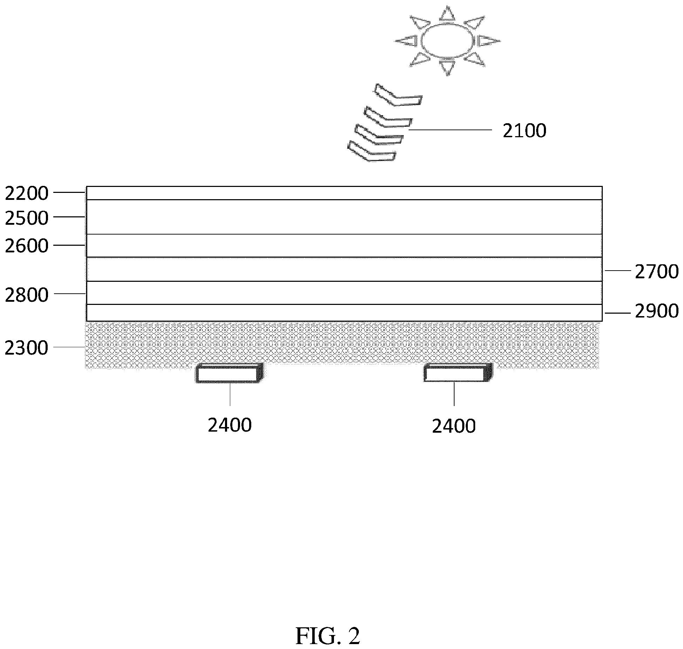

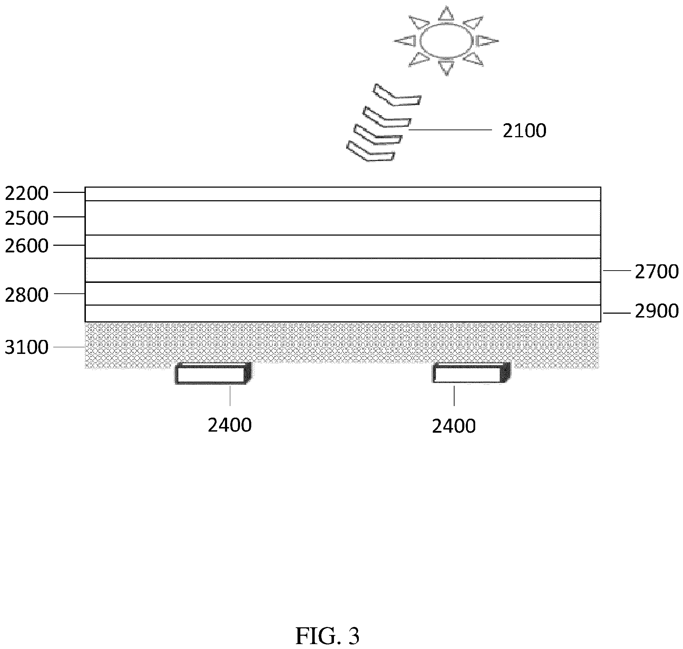

According to an aspect shown in FIG. 2, a layered BIPV system for converting incident photons 2100 into usable energy is comprised of, from the exterior side to the interior side, an antireflective coating 2200, a first substrate 2500, a first encapsulant 2600, an optional transparent conducting oxide (TCO) 2700 where the at least one solar cell 2800 is a thin film solar cell, the at least one solar cell 2800, a second encapsulant 2900, an aluminum honeycomb sandwich panel anchoring element 2300, and stone lamina back rails 2400. According to a further aspect, the first substrate 2500 is printed low iron tempered float glass and the second encapsulant 2900 may encapsulate a metallic back contact. According to an aspect shown in FIG. 3 with an alternative anchoring element 3100, the alternative anchoring element 3100 is a polyvinyl chloride (PVC) sandwich panel with aluminum skin.

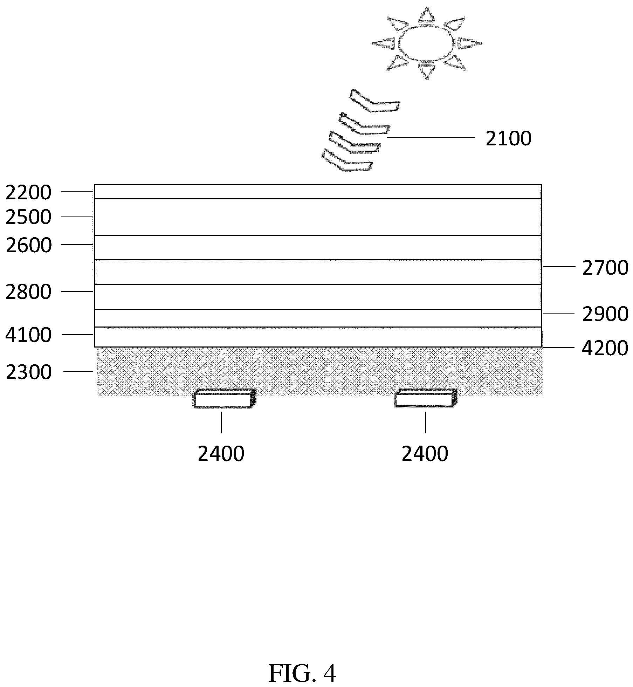

According to an aspect shown in FIG. 4, a layered BIPV system for converting incident photons 2100 into usable energy is comprised of, from the exterior side to the interior side, an antireflective coating 2200, a first substrate 2500, a first encapsulant 2600, an optional TCO 2700 where the at least one solar cell 2800 is a thin film solar cell, the at least one solar cell 2800, a second encapsulant 2900, a second substrate 4100, structural adhesive 4200, an aluminum honeycomb sandwich panel anchoring element 2300, and stone lamina back rails 2400. According to a further aspect, the first substrate 2500 is printed low iron tempered float glass, the second encapsulant 2900 may encapsulate a back contact layer, the second substrate 4100 may be comprised of glass, metal, or at least one Tedlar^{®} back sheet, and the structural adhesive 4200 is an epoxy structural adhesive.

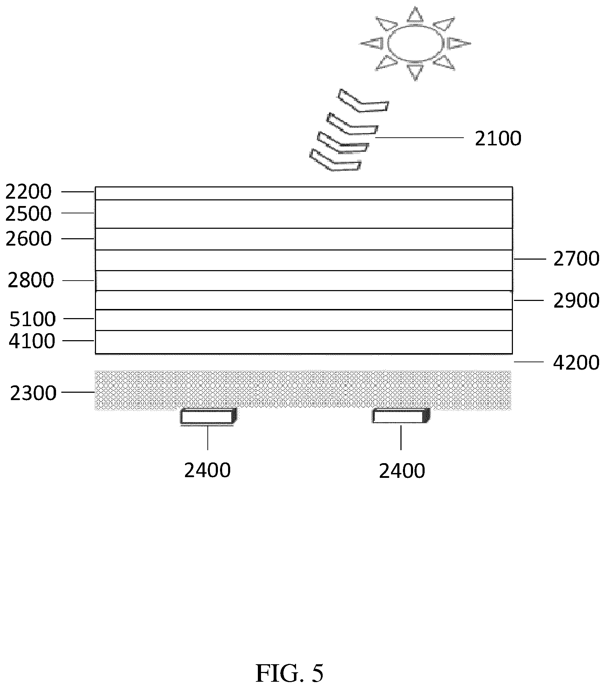

According to an aspect shown in FIG. 5, a layered BIPV system for converting incident photons 2100 into usable energy is comprised of, from the exterior side to the interior side, an antireflective coating 2200, a first substrate 2500, a first encapsulant 2600, an optional TCO 2700 where the at least one solar cell 2800 is a thin film solar cell, the at least one solar cell 2800, a second encapsulant 2900, an insulation layer 5100, a second substrate 4100, structural adhesive 4200, an aluminum honeycomb sandwich panel anchoring element 2300, and stone lamina back rails 2400. According to a further aspect, the second encapsulant 2900 may encapsulate a back-contact layer and the structural adhesive 4200 is an epoxy structural adhesive.

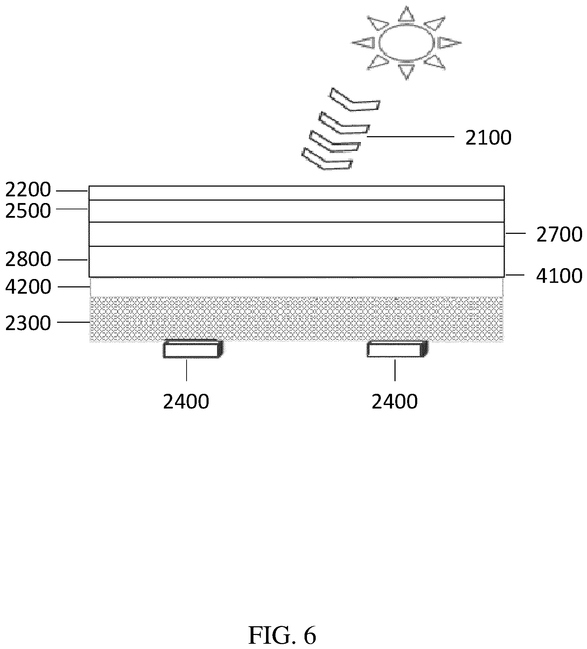

According to an aspect shown in FIG. 6, a layered BIPV system for converting incident photons 2100 into usable energy is comprised of, from the exterior side to the interior side, an antireflective coating 2200, a first substrate 2500 separated by metal spacers from a second substrate 4100 to create a cavity filled with inert gas and sealed with a fire retardant seal and in which is an optional TCO 2700 where the at least one solar cell 2800 is a thin film solar cell and the at least one solar cell 2800, structural adhesive 4200, an aluminum honeycomb sandwich panel anchoring element 2300, and stone lamina back rails 2400. According to a further aspect, the first substrate 2500 and second substrate 4100 are insulating printed low iron tempered float glass.

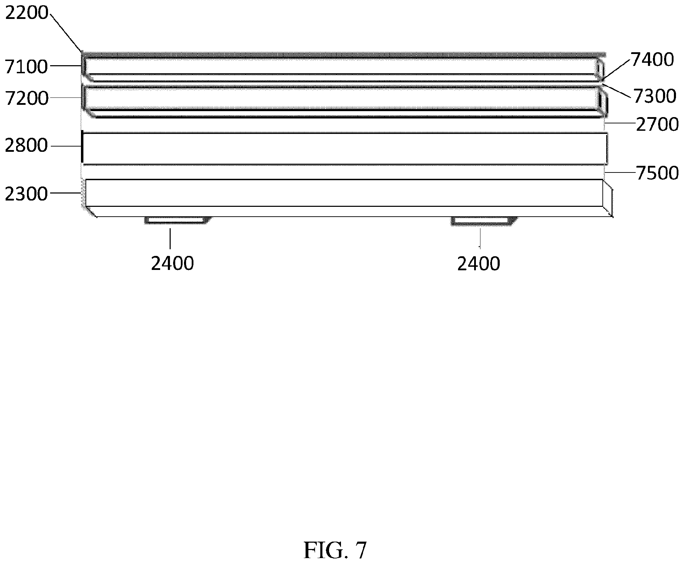

According to an aspect shown in FIG. 7, a layered BIPV system is comprised of, from the exterior side to the interior side, an antireflective coating 2200, a first glass substrate 7100 and second glass substrate 7200 with a printed surface 7300 wherein the first glass substrate 7100 and the second glass substrate 7200 are laminated 7400 with a transparent intumescent coat and encapsulant to improve fire retardance, an optional TCO 2700 where the at least one solar cell 2800 is a thin film solar cell, the at least one solar cell 2800, a back encapsulant layer 7500 with an optional molybdenum layer where the at least one solar cell 2800 is a thin film solar cell, an aluminum honeycomb sandwich panel anchoring element 2300, and stone lamina back rails 2400. According to a further aspect, the printed surface 7300 of the second glass substrate is a digital UV print or screen print.

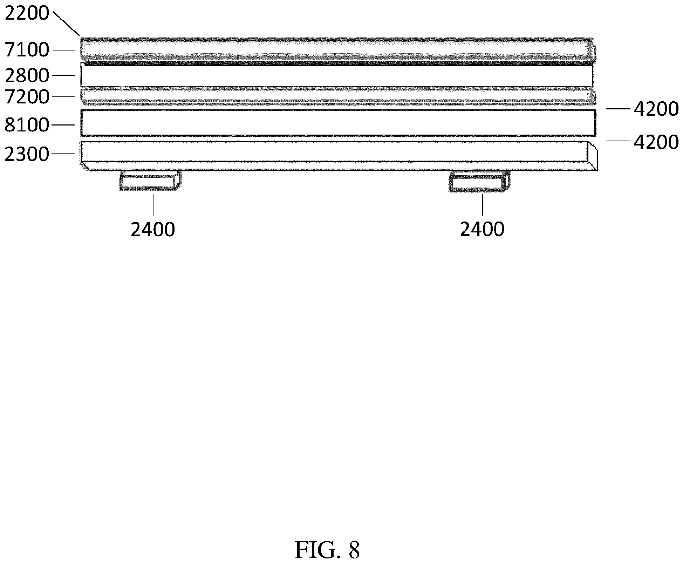

According to an aspect shown in FIG. 8, a layered BIPV system is comprised of, from the exterior side to the interior side, an antireflective coating 2200, a semitransparent thin film solar module that is either coloured or clear and comprised of a first glass substrate 7100 and second glass substrate 7200 on either side of the at least one solar cell 2800, structural adhesive 4200, stone laminate 8100, structural adhesive 4200, an aluminum honeycomb sandwich panel anchoring element 2300, and stone lamina back rails 2400. According to a further aspect, the stone laminate 8100 is a composite panel and the structural adhesive 4200 is an epoxy structural adhesive.

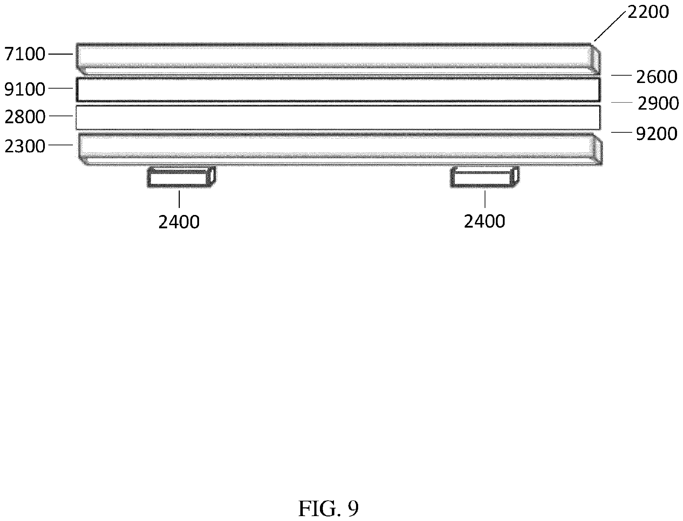

According to an aspect shown in FIG. 9, a layered BIPV system is comprised of, from the exterior side to the interior side, an antireflective coating 2200, a first glass substrate 7100, a first encapsulant 2600, onyx laminate 9100, a second encapsulant 2900, the at least one solar cell 2800, a third encapsulant 9200, an aluminum honeycomb sandwich panel anchoring element 2300, and stone lamina back rails 2400. According to a further aspect, the onyx laminate 9100 is bonded to the first glass substrate 7100 without any printing. According to a further aspect, the first glass substrate 7100 is a composite panel.

### Installing the Layered BIPV System as Cladding on a Building

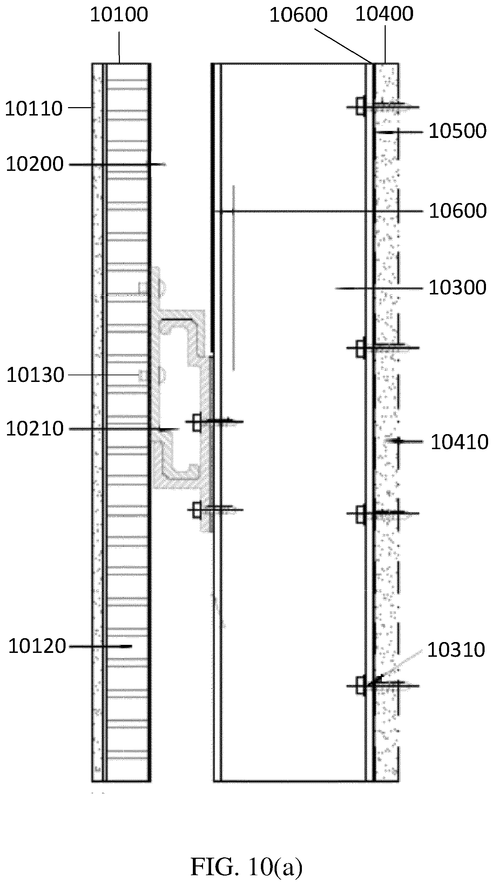

According to an aspect, the layered BIPV system can be installed on a building using a cladding installation method, like as shown in FIGs. 10(a) to 10(c). FIG. 10(a) depicts the installation of the layered BIPV cladding system 10100 with a finished face 10110 which is secured at its back portion 10120 using pop rivets 10130 as required to create a windload and bearing channel 10200 in combination with a field attached interlocking apparatus 10210. The interlocking apparatus is secured to one side of an aluminum z-channel 10300 of variable size using at least one threaded fastener 10310, which may be screws or studded bolts. The other side of the aluminum z-channel 10300 is secured using at least one threaded fastener 10310 to a backwall 10400 that includes sheathing 10410 over the at least one threaded fastener 10310. A vapor barrier sheet 10500 may be installed between the backwall 10400 and the side of the aluminum z-channel 10300 that abuts the backwall 10400. Shims 10600 may be incorporated at either side of the aluminum z-channel 10300 as required to improve fit.

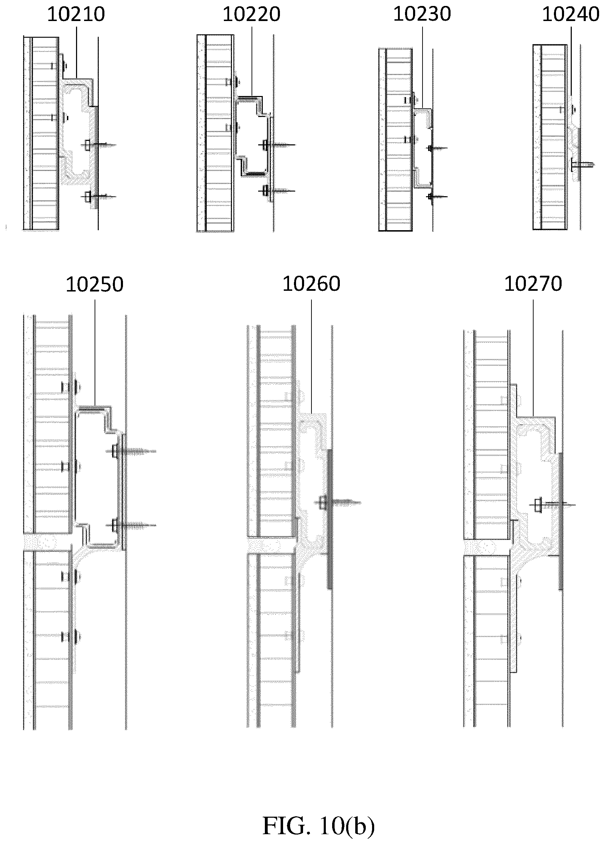

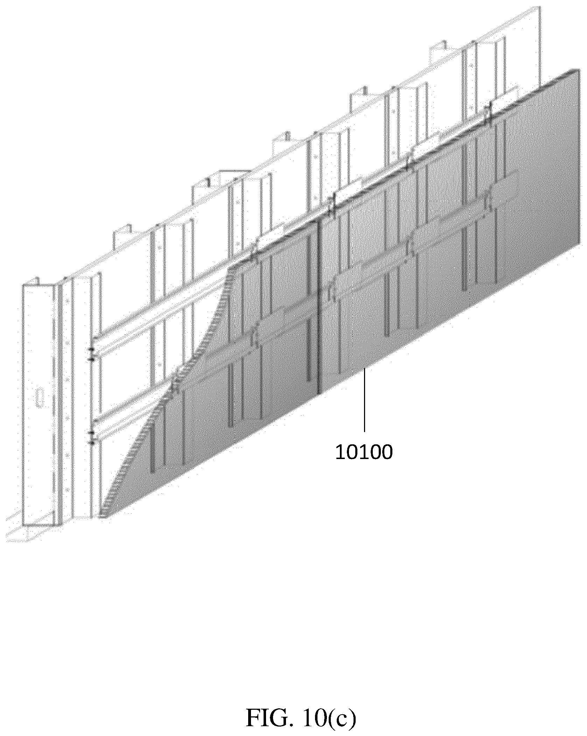

According to aspects shown in FIG. 10(b), the dimensions of the windload and bearing channel 10200 created by an interlocking apparatus 10210 can be modified by replacing interlocking apparatus 10210 with an interlocking apparatus 10220, 10230, 10240, 10250, 10260, or 10270 of different dimensions or design. FIG. 10(c) depicts a cross-section of an installed layered BIPV cladding system 10100.

### Structural Properties

Preferably, the layered BIPV system or an adhesive, substrate, or anchoring element thereof is compliant with at least one American Society for Testing and Materials (ASTM) standard for structural pressure, water penetration, rate of air leakage, large missile impact resistance, cyclic pressure loading, flexural strength, compressive strength, shear strength, or tensile strength and fire retardance of the layered BIPV system is compliant with at least one fire retardance standard from the Standards Council of Canada. Compliance with an ASTM standard may include compliance with at least one of ASTM E330, E331, E283, E1886, E1996, C880, D897, C365, C393.Compliance with at least one fire retardance standard from the Standards Council of Canada includes compliance with CAN/ULC-S 134.

With respect to structural pressure, preferably, when subject to a uniform static air pressure difference of ±3840 Pa, maximum net deflection of a cladding system should not exceed 4.14 mm. Uniform load deflection tests were conducted in accordance with ASTM E330/E330M-14 *"Standard Test Method for Structural Performance of Exterior Windows, Skylights, Doors and Curtain Walls by Uniform Static Air Pressure Difference"* ("ASTM E330") using the sample assembly and description as follows:

| | |
|---|---|
| **Manufacturer Information** | Stone Lamina |
| | 79 Vulcan St. Etobicoke, Ontario, M9W 1L4 |
| **Sample Description** | Exterior Stone Faced Aluminium Cladding System |
| **Mock-up Framing** | • The cladding system was installed onto a mockup framing wall consisting of 16 gage, 6 in. deep studs spaced approximately 16 in. on centre. |
| | • The stud assembly was built within a 2 in. × 10 in. wood buck with an overall measurement of approximately 8 ft. × 8 ft. |
| | • 5/8" plywood sheathing was fastened to the studs using #6 × 1-5/8" self-drilling flat head screws. |
| | • The fasteners were spaced at 8 in. at the stud line and 8 in. around the perimeter of the sheathing. |
| | • 6061 Aluminum 90° Angle 2"x2" and 1/8" wall thickness was installed at the cladding perimeter to enclose the space to the wall sheathing. |
| | • Silicone was then applied to the exterior and interior perimeters between the cladding edges and aluminium angle. |
| **Size** | Overall Size: |
| | • Width: 2440 mm |
| | • Height: 2440 mm |
| **Cladding** | • Stone Lamina Contractors installed 4 ft. x 4ft. stone faced aluminium panels with three (3) tracks per panel spaced at 17 ¾" riveted at the backside of the panel. |
| | • Panel tracks were installed to the plywood sheathing using #12 x 2" pan head screws with plastic shims. Panel tracks were spaced at 16 in. on centre. |
| | • Vertical spacing of tracks was approximately at 18 in. to 20 in. |
| | • Interior joints between panels were sealed using Dow Corning 795 sealant with ¼" backer rod. |

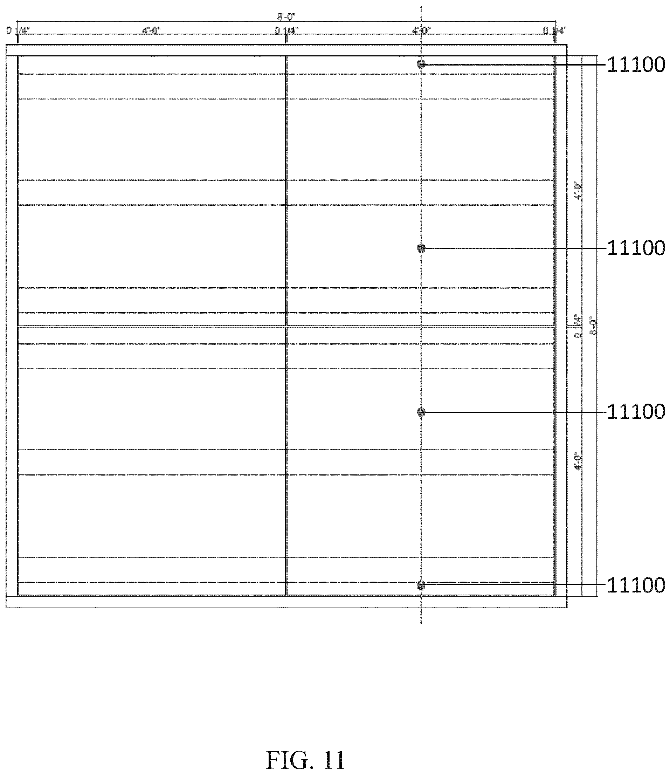

The tests were performed in both the positive and negative directions. After a 10 second preload (50% of the test load), followed by 1 minute with the pressure released, the tests were conducted using a specified test pressure for a period of 10 seconds. Deflections were measured at the vertical mid-span between the gerts and at the ends using deflection gauge locations 11100, as shown in FIG. 11. The end deflections were averaged and subtracted from the mid-span deflection to eliminate deflections caused by movement at the ends of structural supporting members. The test results are as follows:

| Deflection at Design Pressure Test (80 psf) | | |
|---|---|---|
| Member | Vertical Axis | |
| Span Length (L) | 2440 mm | |
| Allowable Deflection (L/175) | 14.0 mm | |
| Test Pressure | ***Positive Load*** | ***Negative Load*** |
| | +3840 Pa | -3840Pa |
| Maximum Net Deflection | 4.14 mm | 4.93 mm |
| Post-test Details | After the test loads were released, the cladding system was Inspected and there was found to be no failure or permanent deformation of any part of the cladding system that would cause any operational malfunction. | |

Additionally, when subject to a uniform status air pressure difference of ±5760 Pa, net permanent deflection of a cladding system should not exceed 0.10 mm for a length of 2.44 m or no more than 0.004% of the length of the substrate or encapsulant. Uniform load structural tests were conducted in accordance with ASTM E330 using the same sample assembly and description as provided above for the uniform load deflection tests. The tests were performed in both the positive and negative directions. After a 10 second preload (50% of the test load), follows by 1 minute with the pressure released, the tests were conducted using a specified test pressure for a period of 10 seconds. After the test loads were released, the permanent deflections were recorded and the specimen was inspected for failure or permanent deformation of any part of the system that would cause any operational malfunction. Polyethylene film was used during positive wind pressure sequences. The test results are as follows:

| Permanent Deflection at Structural Pressure Test (120 psf) | | |
|---|---|---|
| Member | Vertical Axis | |
| Span Length | 2440 mm | |
| Allowable Deflection \|(L × 0.2%) | 4.88 mm | |
| Test Pressure | ***Positive Load*** | ***Negative Load*** |
| | +5760 Pa | FAIL |
| | 0.10 mm | 7.35 mm |
| | After the positive test loads were released, the cladding system was inspected and there was found to be no failure or permanent deformation of any part of the cladding system that would cause any operational malfunction. | |
| | When approaching the negative test load of -5,760 Pa, specifically at 5,006 Pa (104 psf), the rivets at the backside of the panel failed. | |

With respect to water penetration, when a cladding system is subject to a uniform static air pressure difference of 720 Pa with water applied to the exterior side there should be no water penetration. Static water penetration resistance tests were conducted in accordance with ASTM E331-00(R2016) *"Standard Test Method for Water Penetration of Exterior Windows, Skylights, Doors, and Curtain Walls by Uniform Static Air Pressure Difference"* ("ASTM E331") using the same sample assembly and description as provided above for ASTM E330. The tests were performed using the specified pressure differential and a water spray rate of at least 204 L/M² per hour (5.0 gal/ft² per hour). A static pressure was applied continuously for fifteen minutes, during which the water spray was continuously applied. The test results showed that during the 15-minute test period and using a pressure differential of 720 Pa (15.0 psf), there was no water leakage observed. The cladding system met the water penetration resistance performance requirements under ASTM E331.

With respect to air leakage, when a cladding system is subject to an air pressure difference of +75 Pa or -75 Pa the rate of air leakage should not exceed air infiltration and exfiltration levels of 0.00 L/((s)(m²)) or 0.01 L/((s)(m²)), respectively. Air leakage resistance tests were performed in accordance with ASTM E283-04(2012) "Standard Test Method for Determining Rate of Air Leakage Through Exterior Windows, Curtain Walls, and Doors Under Specified Pressure Differences Across the Specimen*"* ("ASTM E283") using the same sample assembly and description as provided above for ASTM E330. The tests were performed using test pressures of 75 Pa (1.57 psf) and 300 Pa (6.27 psf). The maximum air leakage rate was calculated and compared to the allowable air leakage. The test results are as follows:

| | |
|---|---|
| Air Infiltration - 75 Pa | |
| Curtain Wall Area: | 5.95m² |
| Infiltration rate: | 0.00 L/s-m² |
| Air Exfiltration -75 Pa | |
| Curtain Wall Area: | 5.95 m² |
| Exfiltration rate: | 0.01 L/s-m² |

For large missile impact resistance, there should no material structural deformation, deflection, or breakage when a cladding system is impacted with a large missile comprised of lumber with a mass of 4100 g ± 100 g and dimensions 2 inches by 4 inches by 8 feet ± 4 inches at an impact speed of 50 feet/second in wind zones with isotachs of no more than 150 mph. For cyclic pressure loading, there should be no material structural deformation, deflection, or breakage when subject to a cyclic wind pressure of ±2880 Pa after being impacted with the large missile. Impact resistance and cyclic wind load resistance tests were conducted in accordance with ASTM E1886 and ASTM E1996.

The ASTM E1886 and ASTM E1996 test sample was a laminated stone cladding system consisting of a 3003 aluminum allow foil honeycomb cell core sandwiched between two continuous layers of solid aluminum sheathing. On top of the honeycomb is 2-5 mm (0.08 in. - 0.20 in.) of natural stone veneer bonded with epoxy adhesive. Installed on the backside of the panels were channels of approximately 152 mm (6 in.) wide that was secured with 4x 7/16 in. x ¼ in. pop rivets. A total of 6x channels were installed on each panel. Since the test sample was comprised of multiple identical panels, 3x panels were impacted and cycled on a single wall system rather than using a single panel on 3x separate identical wall systems. The wall assembly was a total of 2477 mm x 2477 mm (8ft 1-1/2 in. x 8 ft. 1-1/2 in.) constructed out of 16 ga. 2x6 steel studs spaced 16 in. on-center and sheathed with 5/8 in. std. spruce plywood. The sheathing was secured using #6 x 1-5/8" self-tapping flat-head screws spaced every 203 mm (8 in.) within the field as well as around the perimeter. The steel stud assembly was cladded with nominal 2x12 SPF which was secured using #8 x 1-1/2" pan-head wood screws from the steel side, spaced approximately every 203 mm (8 in.). The butted corners of the 2x12 were secured together using 4x #10 x 3-1/2" flat-head construction screws. Once the stone lamina panels were installed, gaps between panels, as well as between the panels and the 2x12 SPF, were filled with backer rod and sealed with Dow Corning 795.

Each test sample was impacted with a large missile in accordance with ASTM E1886 and ASTM 1996, with the missile speed being calibrated using a doppler radar gun. The missile type used was a Type D missile as follows:

| **Missile ID no.** | **1A** | |
|---|---|---|
| **Lenght (mm / in)** | **2337** | **92** |
| **Distance to Target (mm / in)** | **3505** | **138.0** |
| **Weight (lbs / kg)** | **9.2** | **4.2** |

to qualify for Wind Zones 1-4 for the protection levels as follows:

| Level of Protection | Enhanced Protection (Essential Facilities) | | Basic Protection | | Unprotected | |
|---|---|---|---|---|---|---|
| Assembly Height: | ≤ (30 ft) 9.1 m | > (30 ft) 9.1 m | ≤ (30 ft) 9.1 m | > (30 ft) 9.1 m | ≤ (30 ft) 9.1 m | > (30 ft) 9.1m |
| Wind Zone 1 | D | D | C | A | None | None |
| Wind Zone 2 | D | D | C | A | None | None |
| Wind Zone 3 | E | D | D | A | None | None |
| Wind Zone 4 | E | D | D | A | None | None |

Once impact was completed, each specimen was subjected to cyclic wind load in accordance with ASTM E1886 and ASTM E1996. The test sample was cycled at a design pressure, P, of either +2880 Pa (60.0 psf) for a positive loading direction or -2880 Pa (60.0 psf) for a negative loading direction in accordance with the following schedule:

| Loading Sequence | Loading Direction | Air Pressure Cycles | Number of Air Pressure Cycles |
|---|---|---|---|
| 1 | Positive | 0.2P to 0.5P | 3500 |
| 2 | Positive | 0.0P to 0.6P | 300 |
| 3 | Positive | 0.5P to 0.8P | 600 |
| 4 | Positive | 0.3P to 1.0P | 100 |
| 5 | Negative | 0.3P to 1.0P | 50 |
| 6 | N egative | 0.5P to 0.8P | 1050 |
| 7 | Negative | 0.0P to 0.6P | 50 |
| 8 | Negative | 0.2P to 0.5P | 3350 |

The impact test data is as follows:

| Shot No. | **Shot Location** | **Shot Speed ft/sec** | **Comments/Results** |
|---|---|---|---|
| 1 | Panel #1 - Top Right Corner* | 49.9 | For all 6 shots, missiles penetrated through the panels however no penetration through plywood sheathing. Pass. |
| 2 | Panel #1 - Center | 49.9 | |
| 3 | Panel #2 - Bottom Left Corner | 49.7 | |
| 4 | Panel #2 - Center | 49.6 | |
| 5 | Panel #3 - Bottom Right Corner | 50.0 | |
| 6 | Panel #3 - Center | 49.7 | |

Note that Shot No. 1's impact was high, however it ended up impacting right along a joint edge. Due to the nature of the wall system and the location impacted being a more 'worst case' scenario, testing was continued as is. Upon completion of the cyclic wind load post large missile impact, the system was inspected and there was found to be no tear that formed longer than 130 mm (5") by 1 mm (1/16") wide as well as no opening through which a 76 mm (3") diameter solid sphere could freely pass through. As such, the system met the requirements for ASTM E1886 and ASTM 1996.

Considering flexural strength, there should be no material deformation, deflection, or breakage of a cladding system when subject to a flexural pressure of 2630 psi. For tensile strength, adhesive bonds of the cladding system should not fail when subject to tensile stress of 137 psi. Tests of flexural strength and adhesive bond strength were conducted per ASTM C880/C880M-15 ("ASTM C880") and ASTM D897-08 (2016) ("ASTM D897"). Test samples were allowed to condition at standard laboratory conditions of 73 ± 4 °F and 50 ± 5% relative humidity for at least 40 hours prior to testing. Testing was performed as follows:

| Test Method | Test Method Title | Parameters and/or Deviations from Method |
|---|---|---|
| ASTM C880/C880M-15 | Standard Test Methods for Flexural Strength of Dimensional Stone | 4 pt bend: 4" x 12" specimens |
| | | Test speed: 600 psi/min |
| | | 3 pt bend: 6" x 3" |
| | | Test speed: 0.02"/min |

| Test Method | Test Method Title | Parameters and/or Deviations from Method |
|---|---|---|
| ASTM D897-08 (2016) | Standard Test Method for Tensile Properties of Adhesive Bonds | 2" x 2" specimens Modified method |

Test samples were prepared with the following dimensions and quantities:

| Test Type | Exposure Condition | Specimen IDs | Quantity | Size |
|---|---|---|---|---|
| Flexural | Freeze- Thaw | FT-1, FT-2 | 2 | 4" x 12" |
| | UV-exposed | UV-1 | 1 | 6" x 3" |
| Bond Strength | Freeze-Thaw | FT-1, FT-2 | 2 | 2" x 2" |
| | UV-exposed | UV-1, UV-2 | 2 | 2" x 2" |

All test samples retained stone-metal adhesion during flexural testing. The results of the ASTM C880 flexural strength tests are as follows:

| Specimen | Width, in | Length, in | Depth, in | Peak load, lbf | Ultimate Flexural Strength, psi |
|---|---|---|---|---|---|
| FT-1 | 3.995 | 12.002 | 1.082 | 1325 | 2072 |
| FT-2 | 3.995 | 12.002 | 1.085 | 1333 | 2073 |
| UV-1 | 3.001 | 6.000 | 1.100 | 946 | 1562 |

whereas the test results of the ASTM D897 adhesive bond strength test are as follows:

| Specimen | Width, in | Length, in | Peak Load, lbf | Peak Stress, psi | Comment |
|---|---|---|---|---|---|
| FT-1 | 1.903 | 1.907 | 505 | 139 | Failed at stone |
| FT-2 | 1.880 | 1.978 | 515 | 139 | Failed at stone |
| UV-1 | 1.980 | 2.050 | 687 | 169 | Failed at stone |
| UV-2 | 1.865 | 2.070 | 528 | 137 | Specimen did not fail; failure occurred at adhesive between specimen and tensile substrate |

Considering compressive strength, there should be no material deformation, deflection, or breakage of a cladding system when subject to a compressive pressure of approximately 278 psi (1.92 MPa). For shear strength, there should be no material deformation, deflection, or breakage of a cladding system when subject to a shear pressure of approximately 148 psi (1.02 MPa). Flatwise compressive properties were tested in accordance with ASTM C365/C365M-11a ("ASTM C365") while core shear properties were tested in accordance with ASTM C393/393M-11 ("ASTM C393"). Test samples were constructed as follows:

| General description | | STONE HONEYCOMB COMPOSITE PANEL |
|---|---|---|
| Trade name / product reference | | "HYCOMB" |
| Name of manufacturer | | LIMING HONEYCOMB COMPOSITES CO., LTD |
| Overall thickness | | 28 mm |
| Size(Length × Width) | | 1220 mm x 610 mm |
| Facing | Generic type | Natural stone |
| | Product reference | Cherry red stone |
| | Colour | Cherry red |
| | Thickness | 8 mm |
| | Size(Length × Width) | 1220 mm x 610 mm |
| Adhesive | Generic description | Epoxy Adhesive (two components) |
| | Product reference | ARALDITE - AW 146 CI |
| | | HARDENER - HV 957 |
| | Name of manufacturer | Huntsman Advanced Materials |
| | Application rate | 500 ∼ 600 g/m² |
| | Application method | Gelatinizing and cold pressing |
| Aluminum Alloy Sheet | Generic description | Aluminum Alloy Sheet |
| | Product reference | 3003-H16 |
| | Name of manufacturer | Foshan Scien Aluminium Co., Ltd |
| | Size (Length × Width × Thickness) | 1220 mm x 610 mm x 0.95mm |
| | Tensile strength | More than 150 Mpa |
| Adhesive | Generic description | Thermoplastic Adhesive Film |
| | Trade name / product reference | AH1035 |
| | Name of manufacturer | Guangzhou Lushan New Material Co., Ltd |
| | Thickness | 0.35 ∼ 0.41 mm |
| | Overall weight per unit area | 321.76 g/m² |
| | Application method | Hot pressing |
| Core | Generic description | Aluminium honeycomb core |
| | Name of manufacturer | LIMING HONEYCOMB COMPOSITES CO., LTD |
| | Thickness | 18 mm |
| | Aluminum Foil | Model: 3003-H18 |
| | | Thickness: 0.058 mm |
| | | Tensile strength: more than 190 Mpa |
| | Glue | Nitrile Butadiene Glue |
| | Application method of glue | Hot pressing |
| Adhesive | Generic description | Thermoplastic Adhesive Film |
| | Trade name / product reference | AH1035 |
| | Name of manufacturer | Guangzhou Lushan New Material Co., Ltd |
| | Thickness | 0.35 ∼ 0.41 mm |
| | Overall weight per unit area | 321.76 g/m² |
| | Application method | Hot pressing |
| Facing | Generic description | Aluminum Alloy Sheet |
| | Product reference | 3003-H16 |
| | Name of manufacturer | Foshan Scien Aluminium Co., Ltd |
| | Size (Length × Width x Thickness) | 1220 mm x 610 mm x 0.95mm |
| | Tensile strength | More than 150 Mpa |

Test specimens were conditioned for at least 48 hours at a temperature of 23 ± 2 °C and relative humidity of 50 ± 5%. Flatwise compressive properties were assessed in accordance with ASTM C365 and by subjecting a sandwich core to a uniaxial compressive force normal to the plane of the facings as the core would be placed in a structural sandwich core using loading platens attached to the testing machine. The test results were as follows:

| Sample | Length | Width | Thickness | Ultimate Force | Ultimate Strength |
|---|---|---|---|---|---|
| | (mm) | (mm) | (mm) | (N) | (KPa) |
| 1 | 100.34 | 100.04 | 29.91 | 18482 | 1841 |
| 2 | 100.00 | 100.36 | 29.20 | 21373 | 2130 |
| 3 | 100.36 | 99.74 | 29.68 | 18608 | 1B59 |
| 4 | 99.86 | 100.06 | 29.68 | 20370 | 2039 |
| 5 | 102.48 | 100.18 | 29.78 | 17764 | 1730 |
| Avg. | | | | | 1919.74 |
| DEV. | | | | | 161.21 |
| COV | | | | | 8.40 |

Core shear properties by beam flexure were assessed in accordance with ASTM C393 by subjecting a beam of sandwich construction to a bending moment normal to the plane of the sandwich and recording force versus defection measurements. The test results were as follows:

| Sample | Length | Width | Thickness | Ultimate Force | Ultimate Strength |
|---|---|---|---|---|---|
| | (mm) | (mm) | (mm) ) | (N) | (MPa) |
| 1 | 199 | 74.79 | 29.96 | 3496 | 0.94 |
| 2 | 199 | 14.91 | 29.58 | 3611 | 0.97 |
| 3 | 200 | 75.70 | 29.53 | 4642 | 1.24 |
| 4 | 200 | 74.75 | 29.76 | 3638 | 0.98 |
| 5 | 199 | 74.78 | 30.02 | 3592 | 0.96 |
| Avg. | | | | | 1.02 |
| DEV. | | | | | 0.12 |
| COV | | | | | 12.27 |

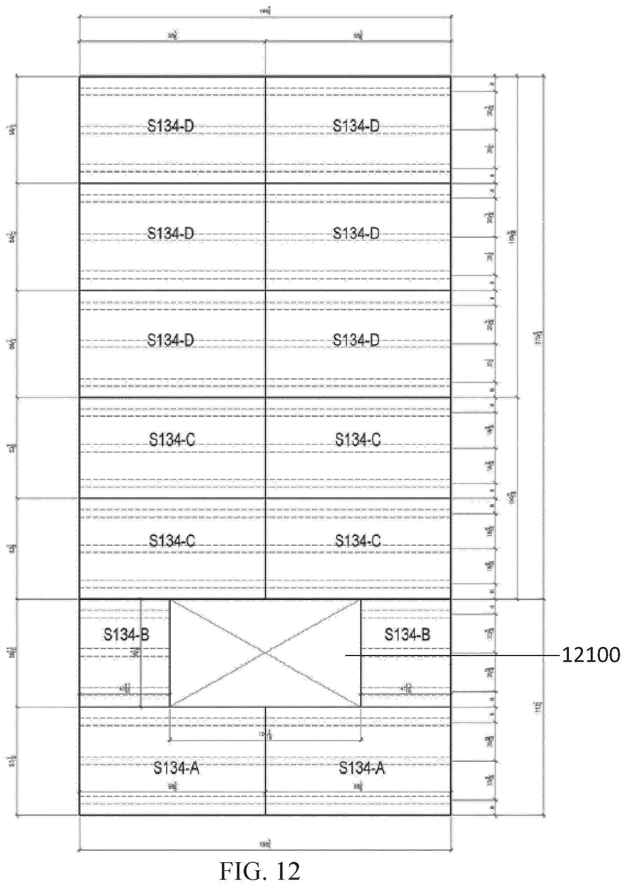

With respect to fire retardance, a cladding system exposed to a post flashover fire in a compartment venting through an opening in the exterior side should result in a maximum flame spread of no more than 2.0 M above the opening or a maximum average heat flux of no more than 14.4 kW/m². Fire resistance of the cladding system was evaluated in accordance with the CAN/ULC-S 134 "Standard Method of Fire Test of Exterior Wall Assemblies, 2nd Edition, dated August 2013 ("CAN/ULC-S134"). Test samples were constructed of a substrate, stone lamina aluminum composite material (ACM) panels, and adhesive. The substrate was comprised of 96 in. x 4 in. aluminum backing applied directly to exterior wall gypsum using 3 in. Tapcons^{®} every 24 in. in two rows up the entire height of the wall; spaced 24 in. on-center vertically with a 4 in. gap in between the rows horizontally. 45 in. x 4 in. aluminum backing was applied directly to the exterior wall gypsum using 3 in. Tapcons^{®} every 24 in. spaced 24 in. horizontally on both sides of a window opening 12100. Stone lamina ACM panels were attached to the substrate as shown in FIG. 12, while Dowsil^{™} 790 Silicone Building Sealant was applied directly in between each panel in a ¼ in. bead before the panels were pushed snug up against each other to create a seal.

Testing was conducted in accordance with the CAN/ULC-S 134 test method. Ambient conditions were 72°F and 81% relative humidity. Anemometers were used to verify ambient air velocity did not exceed 2 m/s as specified in the test method. Video recording, digital photographs, visual observations, and data collection were performed prior, during, and after testing was completed. In accordance with CAN/ULC-S 134, once ambient conditions are met, pilot burners are lit. The test then starts with the ignition of the burners. The burners proceed, controlled as specified in CAN/ULC-S 134, with a 5-minute growth period, followed by a 15-minute steady state period, followed by a 5-minute ramp down period to zero. Three water cooled heat flux transducers (0-100 kW/m²; the "radiometers") were installed through the test sample and the front wall of the test chamber 3.5 m above the top of the window opening 12100; one within 0.2 m ± 0.05 m horizontally of the center line of the opening 12100 and one on each side and within 0.5 ± 0.1 m horizontally from the first. The transducers were installed so that their sensing faces were flush with the outer face of the test sample. 24 GA (0.51 mm), Type K, bare beaded thermocouples were used to monitor temperature of the specimen and were located approximately 89 mm to the right of the vertical center line and above the opening 12100 at 1.5 ± 0.05 m, 2.5 ± 0.05 m, 4.5 ± 0.05 m, and 5.2 ± 0.05 m. At each of these levels, one thermocouple was installed on the outermost ridge of the test sample, and one on the outer face of each representative layer within the specimen. The assembly was instrumented with fifteen thermocouples at the prescribed heights in two levels: one flush with the exterior panels and a second level flush with the outside of the exterior panels. The output of the transducers and thermocouples were monitored by a National Instruments CDAQ-9188 Data Acquisition Unit, which was programmed to scan and save data every 5 seconds.

The acceptance criteria, in accordance with Clause 10.2 of CAN/ULC-S 134 requires flaming on or in the wall assembly to not spread more than 5 m above the opening 12100 in the test sample and the average heat flux to not exceed more than 35 kW/m² measured 3.5 m above the opening 12100 in the test specimen. The maximum flame spread was only 2.0 m above the opening 12100 throughout the test, while the maximum average heat flux was only 14.4 kW/m².

Various embodiments of the invention have been described in detail. Since changes in and or additions to the above-described best mode may be made the invention is not to be limited to those details. Section headings herein are provided as organizational cues. These headings shall not limit or characterize the invention set out in the appended claims.

## Claims

1. A layered building-integrated photovoltaic system, comprising:
an antireflective coating;
at least one substrate;
at least one solar cell;
an anchoring element;
stone lamina back rails;
an exterior side;
an interior side; and
at least one fastener, the fastener comprised of one of: a mechanical fastener and an adhesive,
wherein the at least one fastener is used to connect any combination of the at least one substrate, the at least one solar cell, the anchoring element, and the stone lamina back rails; and
wherein at least one of the at least one substrate has an aesthetic feature comprised of one or more of: visible stone, glass, or other materials.

2. The system of claim 1, wherein the at least one solar cell comprises one of: a crystalline silicon solar cell with a solar light redirecting film, an integrated back contact crystalline silicon solar cell, a thin film solar cell, a thin film solar cell with a transparent conducting oxide layer, and a heterojunction solar cell.

3. The system of claim 1 or 2, wherein the anchoring element is comprised of one of: an aluminum honeycomb sandwich panel and a polyvinyl chloride (PVC) foam core sandwiched between 0.5 mm to 2.0 mm thick aluminum sheets.

4. The system according to any one of the preceding claims, wherein when the aesthetic feature is comprised of glass, the glass is created from at least one of: glass tinting, screen printing, ceramic frit printing, digital UV printing, sputtering, and textured glass, any of which may be tempered, and wherein when the aesthetic feature is comprised of visible stone, the visible stone is comprised of one or more of: limestone, marble, granite, onyx, and other stone laminates.

5. The system according to any one of the preceding claims, wherein the at least one substrate is comprised of one or more of: thin lime soda glass, metal, a Tedlar film, low iron float glass, and another glass and wherein the at least one substrate further comprises one of: no coating, a UV-resistant coating and an insulating coating.

6. The system according to any one of the preceding claims, wherein, from the exterior side to the interior side, there is positioned the antireflective coating, a first substrate, a first encapsulant, the at least one solar cell, a second encapsulant, the anchoring element, and the stone lamina back rails.

7. The system of claim 6, further comprised of one or more of: a second substrate between the second encapsulant and the anchoring element, an insulating layer between the second encapsulant and the second substrate, a fire retardant sealant and a moisture barrier sealant.

8. The system according to any one of the preceding claims, wherein, from the exterior side to the interior side, there is positioned the antireflective coating, a first substrate separated by metal spacers from a second substrate to create a cavity sealed with a fire retardant seal and filled with an inert gas, and in which cavity is positioned the at least one solar cell, the anchoring element, and the stone lamina back rails.

9. The system according to any one of the preceding claims, wherein, from the exterior side to the interior side, there is positioned the antireflective coating, a first substrate laminated with a transparent intumescent coat and a first encapsulant to a second substrate with a printed surface, the at least one solar cell, a second encapsulant, the anchoring element, and the stone lamina back rails.

10. The system according to any one of the preceding claims, wherein, from the exterior side to the interior side, there is positioned the antireflective coating, a semitransparent thin film solar module that is comprised of a first and second glass substrate on either side of the at least one solar cell, stone laminate secured using structural adhesive, the anchoring element, and the stone lamina back rails.

11. The system according to any one of the preceding claims, wherein, from the exterior side to the interior side, there is positioned the antireflective coating, a first substrate comprised of glass, a first encapsulant, a second substrate comprised of onyx laminate, a second encapsulant, the at least one solar cell, a third encapsulant, the anchoring element, and the stone lamina back rails.

12. The system according to any one of the preceding claims, wherein one or more of the system, the substrate, the anchoring element and the adhesive are compliant with one or more standards for: structural pressure, water penetration, rate of air leakage, large missile impact resistance, cyclic pressure loading, flexural strength, compressive strength, shear strength, and tensile strength.

13. The system of claim 12, wherein the one or more standards includes one or more of: ASTM E330, ASTM E331, ASTM E283, ASTM E1886, ASTM E1996, ASTM C880, ASTM D897, ASTM C365, and ASTM C393.

14. The system according to any one of the preceding claims, wherein the system is compliant with at least one fire retardant standard.

15. The system of claim 14, wherein the at least one fire retardant standard includes CAN/ULC-S 134.
